# EUROPEAN PATENT APPLICATION

(11) **EP 1 138 809 A1**
(43) Date of publication of application: **04.10.2001**
(21) Application number: 00956804.9
(22) Date of filing: 30.08.2000
(51) Int. Cl.: C30B 29/06, H01L 21/208

(54) **SILICON WAFER AND METHOD FOR MANUFACTURING THE SAME**

(30) Priority: 06.09.1999 JP 25148299
(71) Applicant: Shin-Etsu Handotai Co., Ltd, Tokyo 100-0005 (JP)
(72) Inventor: KOBAYASHI, Norihiro, Isobe R & D Center, Annaka-shi, Gunma 379-0196 (JP); AKIYAMA, Shoji, Isobe R & D Center, Annaka-shi, Gumma 379-0196 (JP); TAMATSUKA, Masaro, Isobe R & D Center, Annaka-shi, Gunma 379-0196 (JP); SHINOMIYA, Masaru, Isobe R & D Center, Annaka-shi, Gunma 379-0196 (JP)
(74) Representative: Cooper, John
(86) International application number: JP0005872
(87) International publication number: WO0118285

(57) **Abstract**

The present invention provides a silicon wafer doped with boron and nitrogen, wherein boron concentration in a surface layer of a depth of at least 0.2 µm from a surface of the silicon wafer is 1/2 or less of boron concentration of bulk portion, density of defects having a size of 0.09 µm or more in the surface layer is 1.0 × 10¹⁴ defects/cm³ or less, and density of bulk micro defects in the bulk portion after oxygen precipitation heat treatment is 1 × 10⁸ to 2 × 10¹⁰ defects/cm³, and a method for producing a silicon wafer, which comprises growing a silicon single crystal ingot doped with boron and nitrogen by the Czochralski method, processing the single crystal ingot into a silicon wafer by slicing the ingot, and subjecting the silicon wafer to a heat treatment in a hydrogen-containing atmosphere to out-diffuse boron of wafer surface. Thus, there are provided a silicon wafer that can be used as an alternative of p/p⁺ epitaxial wafers and a method for producing the same.

## Description

### Technical Field

The present invention relates to a silicon wafer that can be used as an alternative of silicon epitaxial wafers used for fabrication of semiconductor devices, and a method for producing the same.

### Background Art

With recent use of markedly higher integration degree and higher performance of semiconductor devices, the requirements for crystallinity of silicon wafers used as substrates therefor have become more exacting.

As conventional substrates for DRAM or MPU, CZ wafers produced by the Czochralski method (CZ method), with which substrates of a larger diameter can easily be produced, have mainly been used. However, such CZ wafers contain so-called grown-in defects introduced into the CZ wafers during growing of silicon single crystals, and influence of the defects has made problems including degradation of device characteristics and reduction of yield more significant. Therefore, techniques for reducing the grown-in defects have recently been developed by devising the growing conditions of CZ method, and wafers obtained from CZ single crystals with few grown-in defects or epitaxial wafers with no grown-in defect have come to be used.

However, in order to grow CZ single crystals with few grown-in defects, the crystals must be pulled under a state in which the pulling conditions are very strictly controlled. Therefore, there has arisen a problem of reduction of the yield of CZ wafers themselves, and as a result, increase of cost.

Further, there have been also developed techniques for forming a low defect layer as a surface layer of CZ wafer by subjecting a CZ wafer having grown-in defects to a heat treatment in a reducing atmosphere at a high temperature to eliminate grow-in defects existing near the surface of CZ wafer. However, it has become clear that such techniques cannot necessarily eliminate the defects to a satisfactory degree, while they exhibit defect-reducing effect to a certain extent.

Meanwhile, as for epitaxial wafers, since an epitaxial layer is formed on a CZ wafer produced under ordinary conditions, they have an advantage that those exhibiting extremely superior crystallinity can be obtained, and thus device characteristics and yield of devices to be produced may be markedly improved. However, on the other hand, since they require an additional step of forming an epitaxial layer utilizing an expensive epitaxial growth apparatus, they also inevitably invite increase of cost.

In addition, oxygen precipitation nuclei present in bulk portions of CZ wafers are solubilized by the heat treatment during the epitaxial growth, and hence formation of oxide precipitates in the bulk portions becomes insufficient even if heat treatment for device process is performed. Thus, they suffer from a problem of insufficient gettering ability for heavy metal impurities generated in the process. Therefore, in the conventional production of epitaxial wafers, p/p⁺ epitaxial wafers are often used, in which a p⁺ wafer of high boron concentration (for example, 3 x 10¹⁸ or more number/cm³, 0.02 Ω•cm or less) having high gettering effect is used and a p-type epitaxial layer with a relatively low boron concentration is formed thereon.

However, when such p/p⁺ epitaxial wafers are produced, there are likely to arise a problem that the autodoping phenomenon becomes likely to occur, in which boron evaporated from p⁺ wafers during the epitaxial growth is taken up again into epitaxial layers, or boron is taken up from p⁺ wafer surfaces into epitaxial layers due to solid phase out-diffusion. Since resistivity of the epitaxial layers is changed by this autodoping, there is required a certain countermeasure such as coating of back surface of p⁺ wafers with SiO₂ formed by the CVD method, and this constitutes a cause of further degradation of productivity and cost.

Further, there is recently a trend of using p/p⁻ epitaxial wafers produced by forming a p-type epitaxial layer on a p⁻ wafer having a relatively low boron concentration (for example, around 0.1-50 Ω•cm) as epitaxial silicon wafers for CMOS devices. However, although such wafers do not suffer from the problem of autodoping, they suffer from a problem of lower gettering ability compared with the p/p⁺ epitaxial wafers.

Meanwhile, there is disclosed a method of controlling boron concentration of wafer surface layers by subjecting wafers containing boron to a heat treatment in a hydrogen atmosphere (refer to Japanese Patent Laid-open (Kokai) Publication No. 10-144697). According to this method, there can be obtained a p/p⁺ wafer in which a p-type layer having a relatively low boron concentration is formed as a surface layer of a p⁺ wafer having a high boron concentration, for example, the boron concentration in the surface layer within a depth of at least 0.2 µm from the surface of the silicon wafer is 1/2 or less of the boron concentration of the bulk portion, and there can be obtained a wafer having a boron concentration distribution similar to that of p/p⁺ epitaxial wafer.

However, the aforementioned grown-in defects remain in the surface layer of such a p/p⁺ wafer, and the defects cannot be sufficiently eliminated even if it is subjected to a heat treatment in a hydrogen atmosphere or the like. Therefore, such a wafer as it is cannot be used under the same conditions as epitaxial wafers, and an epitaxial layer must be formed on the surface of that p/p⁺ wafer in order to enable use thereof under the same conditions. Thus, productivity and cost are unavoidably degraded.

### Disclosure of the Invention

The present invention was accomplished in view of such problems, and its object is to provide a silicon wafer that can be used as an alternative of p/p⁺ epitaxial wafers used for the fabrication of semiconductor devices and a simple method for producing it with an extremely low cost.

The present invention for achieving the aforementioned object provides a silicon wafer doped with boron and nitrogen, wherein boron concentration in a surface layer of a depth of at least 0.2 µm from a surface of the silicon wafer is 1/2 or less of boron concentration of bulk portion, density of defects having a size of 0.09 µm or more in the surface layer is 1.0 × 10⁴ defects/cm³ or less, and density of bulk micro defects in the bulk portion after oxygen precipitation heat treatment is 1 × 10⁸ to 2 × 10¹⁰ defects/cm³.

Since such a silicon wafer doped with boron and nitrogen as mentioned above, wherein boron concentration in a surface layer of a depth of at least 0.2 µm from a surface of the silicon wafer is 1/2 or less of boron concentration of bulk portion, density of defects having a size of 0.09 µm or more in the surface layer is 1.0 × 10⁴ defects/cm³ or less, and density of bulk micro defects in the bulk portion after oxygen precipitation heat treatment is 1 × 10⁸ to 2 × 10¹⁰ defects/cm³, contains few grown-in defects in the surface layer, it provides device characteristics comparable to those of epitaxial layer. In addition, since the surface layer has a boron concentration of 1/2 or less of that of the bulk portion, the surface layer can be treated as an equivalent of an epitaxial layer of p/p⁺ epitaxial wafer. Further, since oxygen precipitation nuclei that are not eliminated even after a heat treatment at a high temperature are present in the bulk portion, sufficient bulk micro defects can be formed by a heat treatment of gettering heat treatment, device process or the like, and superior gettering effect against impurities of heavy metals and so forth is exhibited.

In this case, nitrogen concentration of the aforementioned silicon wafer is preferably 1 × 10¹⁰ to 5 × 10¹⁵ number/cm³.

This is because, in order to suppress the formation of grown-in defects of a large size in a boron-doped silicon wafer and to obtain effect of sufficiently promoting oxygen precipitation with nitrogen, the concentration is desirably 1 × 10¹⁰ number/cm³ or more, and because, in order not to prevent single crystallization of silicon single crystals in the Czochralski method, it is desirably 5 × 10¹⁵ number/cm³ or less.

Furthermore, the boron concentration in the bulk portion of the aforementioned silicon wafer is preferably 1 × 10¹⁷ number/cm³ or more.

This is because a higher boron concentration in the wafer bulk portion further increases the gettering effect and provides stronger effect of eliminating heavy metal impurities in the wafer surface layer.

The present invention further provides a method for producing a silicon wafer, which comprises growing a silicon single crystal ingot doped with boron and nitrogen by the Czochralski method, processing the single crystal ingot into a silicon wafer by slicing the ingot, and subjecting the silicon wafer to a heat treatment in a hydrogen-containing atmosphere to out-diffuse boron of wafer surface.

If a silicon wafer is produced by growing a silicon single crystal ingot doped with boron and nitrogen by the Czochralski method, processing the single crystal ingot into a silicon wafer by slicing the ingot, and subjecting the silicon wafer to a heat treatment in a hydrogen-containing atmosphere to out-diffuse boron of wafer surface as described above, a wafer having few grown-in defects in a wafer surface layer and a boron concentration in the wafer surface layer lower than that of the bulk portion can be produced. Such a wafer is also excellent in the gettering effect, and thus a silicon wafer that can satisfactorily used as an alternative of a p/p⁺ or p/p⁻ epitaxial silicon wafer can be produced. Further, if a silicon wafer is produced by this method, the heat treatment for epitaxial growth is no longer required, and thus the production cost of wafers can markedly be improved.

In the above method, when a silicon single crystal ingot doped with boron and nitrogen is grown by the Czochralski method, concentration of nitrogen doped in the single crystal ingot is preferably controlled to be 1 × 10¹⁰ to 5 × 10¹⁵ number/cm³.

This is because, in order to obtain a size of grown-in defects that can be sufficiently eliminated by a heat treatment, the concentration is preferably 1 × 10¹⁰ number/cm³ or more, and because a concentration of 5 × 10¹⁵ number/cm³ or more may inhibit the single crystallization.

Further, when a silicon single crystal ingot doped with boron and nitrogen is grown by the Czochralski method, concentration of boron doped in the single crystal ingot is preferably controlled to be 1 × 10¹⁷ number/cm³ or more.

This is because such a high boron concentration further increases the gettering effect.

Furthermore, the aforementioned hydrogen-containing atmosphere is preferably 100% hydrogen atmosphere, and temperature of the aforementioned heat treatment is preferably 1100°C or more.

If the hydrogen-containing atmosphere is 100% hydrogen atmosphere and the heat treatment temperature is 1100°C or more as mentioned above, the boron of the wafer surface can be more effectively out-diffused, and grown-in defects of the surface layer can surely be eliminated.

As explained above, according to the present invention, a silicon wafer that can be used as an alternative of p/p⁺ epitaxial wafers can be produced with high productivity in a simple manner by growing a silicon single crystal ingot doped with boron and nitrogen by the Czochralski method, and subjecting a silicon wafer obtained from the single crystal ingot to a heat treatment in a hydrogen-containing atmosphere to out-diffuse boron of wafer surface.

### Brief Explanation of the Drawings

Fig. 1 represents a graph showing comparison of defect densities of wafer surface layers of boron-doped wafers obtained with or without annealing and with or without nitrogen doping.
Fig. 2 represents a graph showing comparison of TZDB characteristics of boron-doped wafers obtained with or without nitrogen doping.

### Best Mode for Carrying out the Invention

Hereafter, embodiments of the present invention will be explained in detail. However, the present invention is not limited to these.

The inventors of the present invention conceived that the finding that grown-in defects of a surface of silicon wafer can be extremely efficiently eliminated by subjecting a silicon wafer obtained with a technique of doping nitrogen during growth of silicon single crystal by the CZ method to a heat treatment was applied to the technique of out-diffusing boron present near a wafer surface by subjecting a wafer doped with boron to a heat treatment in a hydrogen-containing atmosphere. And they conceived that a silicon wafer that can be used as an alternative of, for example, p/p⁺ epitaxial wafer, can be produced with an extremely low cost in a simple manner, and investigated various conditions therefor. Thus, they accomplished the present invention.

That is, it has been noted that, if nitrogen is doped in a silicon single crystal, the agglomeration of vacancies in the silicon is inhibited (T. Abe and H. Takeno, Mat. Res. Soc. Symp. Proc., Vol. 262, 3, 1992). It is thought that this effect is obtained because the agglomeration process of vacancies is shifted from that consisting of homogenous nucleus formation to that consisting of heterogenous nucleus formation. Therefore, if nitrogen is doped in a silicon single crystal when it is grown by the CZ method, size of grown-in defects such as void defects formed with agglomeration of vacancies can be made extremely small, and crystal defects of such a small size can be easily eliminated by a heat treatment.

Furthermore, it is also known that, if nitrogen is doped in a silicon single crystal, an effect of promoting oxygen precipitation is exerted and thus oxide precipitate density becomes higher (refer to, for example, F. Shimura and R.S. Hockett, Appl. Phys. Lett., 48, 224, 1986). Therefore, by subjecting a wafer to a heat treatment, the oxide precipitates of the wafer surface are eliminated by out-diffusion of oxygen, and a wafer having a high density of oxide precipitates in a bulk portion and high gettering ability can be produced.

By the way, the aforementioned Japanese Patent Laid-open (Kokai) Publication No. 10-144697 discloses a method of controlling boron concentration in a wafer surface layer by subjecting a silicon wafer containing boron to a heat treatment in a hydrogen atmosphere. This method is based on the finding that out-diffusion of boron is not substantially caused by a heat treatment in an argon atmosphere, but boron in the wafer surface layer can be out-diffused by a heat treatment in a hydrogen-containing atmosphere, and provides a p/p⁺ silicon wafer in which a low boron concentration layer is formed as a surface layer of wafer by subjecting the wafer having a high boron concentration to a heat treatment in a hydrogen-containing atmosphere utilizing the aforementioned phenomenon.

Therefore, the above method enables production of p/p⁺ wafers by subjecting p⁺ wafers having a high boron concentration to a heat treatment in a hydrogen-containing atmosphere without causing the problem of autodoping. However, it was expected that, although a desired resistivity could be obtained by controlling boron concentration of wafer surface layer utilizing this technique, grown-in defects should remain in the wafer surface layer even after the heat treatment in the hydrogen-containing atmosphere.

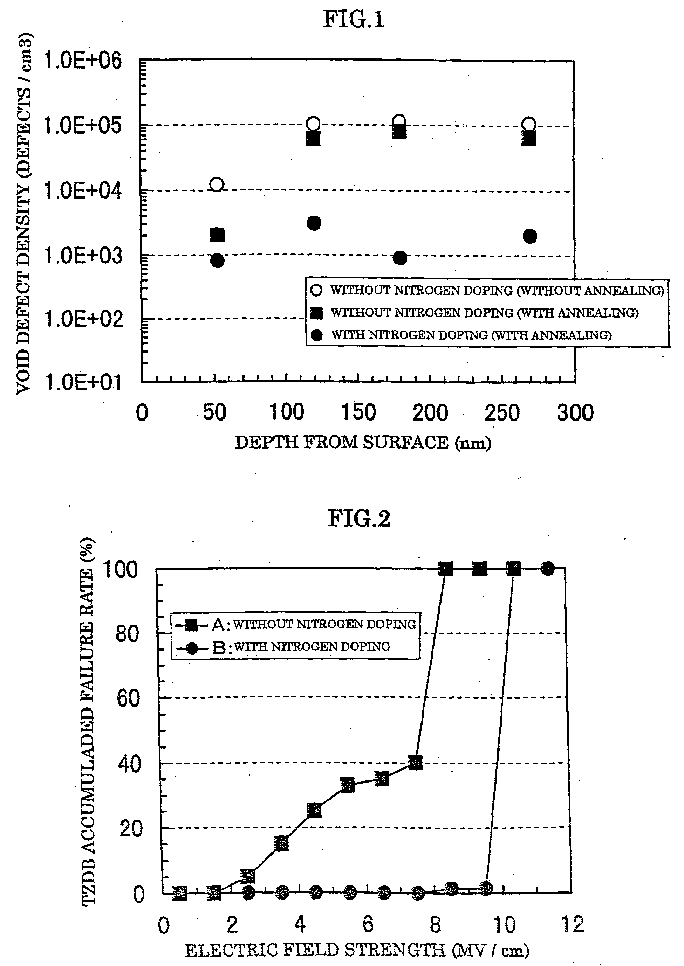

Therefore, the inventors of the present invention prepared a silicon wafer having a boron concentration of about 1 × 10¹⁸ number/cm³ by the ordinary CZ method, subjected it to a heat treatment at 1200°C for 60 minutes in a hydrogen atmosphere, and measured accumulated failure rate for TZDB (Time Zero Dielectric Breakdown) as oxide dielectric breakdown voltage characteristic in a region of a depth of about 0.5 µm from the surface. The results are shown in Fig. 2.

From Curve A shown in Fig. 2, it can be seen that breakdown frequency has become high in an electric field strength range of 3-6 MV/cm. The breakdown in this range is called B-mode failure. That is, this indicates that grown-in defects have remained in the region of a depth of about 0.5 µm from the wafer surface even if the wafer has been subjected to a heat treatment at 1200°C for 60 minutes in a hydrogen atmosphere. This means that it has been confirmed that the grown-in defects near the wafer surface have not been sufficiently eliminated even if the technique disclosed in Japanese Patent Laid-open (Kokai) Publication No. 10-144697 has been applied to a wafer produced by the usual CZ method with doping of boron.

Then, the inventors of the present invention conceived application of the technique of Japanese Patent Laid-open (Kokai) Publication No. 10-144697 to such a CZ silicon wafer doped with nitrogen as mentioned above. This would make the size of grown-in defects in a silicon single crystal small because of the nitrogen doping, and therefore it is expected that the defects come more likely to be eliminated by the heat treatment in a hydrogen-containing atmosphere.

The inventors of the present invention prepared a silicon wafer doped with nitrogen having a nitrogen concentration of 1 × 10¹⁴ number/cm³ and the same boron concentration as mentioned above, i.e., about 1 × 10¹⁸ number/cm³, by CZ method, similarly subjected it to a heat treatment at 1200°C for 60 minutes in a hydrogen atmosphere, and measured accumulated failure rate for TZDB as oxide dielectric breakdown voltage characteristic in a region of a depth of about 0.5 µm from the surface. The results are also shown in Fig. 2.

From Curve B shown in Fig. 2, it can be seen that breakdown frequency in the wafers doped with nitrogen became high in a region exceeding an electric field strength of 8 MV/cm, which electric field strength is called C-mode, and thus the C-mode yield was high. That is, this indicates that the grown-in defects in the wafer surface layers were eliminated by the doping with nitrogen and the heat treatment. Therefore, a p/p⁺ wafer having a small crystal defect density in a wafer surface layer comparable to that of an epitaxial wafer can be obtained by growing a silicon single crystal doped with boron and further doped with nitrogen by the CZ method, and subjecting a wafer obtained from the single crystal to a heat treatment in a hydrogen-containing atmosphere to out-diffuse boron of the wafer surface.

In the present invention, in order to grow a silicon single crystal ingot doped with boron and further doped with nitrogen by the Czochralski method, a known method such as the method disclosed in Japanese Patent Laid-open (Kokai) Publication No. 60-251190 may be used.

That is, the Czochralski method comprises contacting a seed crystal with a melt of polycrystal silicon raw material contained in a quartz crucible, and slowly pulling it with rotation to grow a silicon single crystal ingot having an intended diameter. In such a method, nitrogen can be doped in the pulled silicon single crystal, for example, by preliminarily introducing nitride into the quartz crucible together with polycrystal silicon raw material doped with boron, adding nitride into the silicon melt, or using an atmospheric gas containing nitrogen. The doping amount of nitrogen in the crystal can be adjusted by controlling the amount of nitride, concentration or time of introduction of nitrogen gas.

As for the reason for the promotion of agglomeration of oxygen atoms in silicon and increase of the oxide precipitate density, it is considered to be due to the shift of agglomeration process of oxygen atoms from that consisting of homogenous nucleus formation to that consisting of heterogenous nucleus formation in which impurity nitrogen serves as nuclei as described above.

Therefore, the concentration of nitrogen to be doped is preferably 1 × 10¹⁰ number/cm³ or higher, in which range the heterogenous nucleus formation is sufficiently caused. The oxide precipitate density can sufficiently be made high with such a concentration of the doped nitrogen. On the other hand, if the nitrogen concentration exceeds 5 × 10¹⁵ number/cm³, which is the solid solubility limit of nitrogen in a silicon single crystal, the single crystallization of the silicon single crystal itself may be inhibited. Therefore, it is preferred that it does not exceed that concentration.

Further, the concentration of boron to be doped is preferably 1 × 10¹⁷ number/cm³ or more. This is because such a high boron concentration further promotes the oxygen precipitation in the wafer bulk portion. Further, if the boron concentration is at such a level, the boron in the wafer surface layer can easily be out-diffused by the subsequent heat treatment in a hydrogen-containing atmosphere.

In this way, a silicon single crystal ingot doped with boron and nitrogen of a desired concentration and having a small size of grown-in defects can be obtained by the Czochralski method. This ingot is sliced by using a cutting machine such as an inner diameter slicer or wire saw, and subjected to steps of chamfering, lapping, etching, polishing and so forth to be processed into silicon single crystal wafers in a conventional manner. Of course, these steps are mere examples, and there may be used various other steps such as cleaning and heat treatment. Further, the steps are used with suitable modification including the alteration of the order of the steps, omission of some steps and so forth.

Then, the obtained silicon wafer doped with boron and nitrogen is subjected to a heat treatment in a hydrogen-containing atmosphere. By this heat treatment, boron existing in the wafer surface layer can be out-diffused to easily produce a p/p⁺ wafer.

In this case, if the heat treatment is performed at a temperature of 1100°C or higher in 100% hydrogen atmosphere, boron can be more effectively out-diffused, and the defects of the surface can surely be eliminated.

On the other hand, since the high boron concentration is still maintained in the bulk portion of the wafer, and in addition, the wafer is doped with nitrogen, bulk micro defects are generated in an appropriate density by an oxygen precipitation heat treatment, and thus it becomes a wafer exhibiting high gettering effect.

Hereafter, the present invention will be specifically explained with reference to the following example and comparative example. However, the present invention is not limited to these.

### (Example)

Raw material polycrystal silicon added with boron at such a predetermined concentration that a resistivity should become 0.1-0.01 mΩ•cm was charged into a quartz crucible having a diameter of 24 inches together with silicon wafers having a silicon nitride film, and melted. A single crystal ingot of p-type having a diameter of 8 inches and orientation <100> was pulled from the melt by the CZ method. A wafer was sliced from this single crystal ingot at such a position that the nitrogen concentration should become 1 × 10¹⁴ number/cm³ according to calculation utilizing segregation coefficients, and processed into a mirror-polished wafer. The produced wafer had a resistivity of about 0.07 Ω•cm (boron concentration was about 1 × 10¹⁸ number/cm³).

This wafer was subjected to a heat treatment at 1200°C for 60 minutes in 100% hydrogen atmosphere, and a thermal oxide film was formed on the wafer surface. Then, void defect density (for those having a size of 0.09 µm or more) was measured along the depth direction by measuring LPD (Light Pattern Defect) through the oxide film using a particle counter (SP-1 produced by KLA/Tencor Co., Ltd.). The measurement results are shown in Fig. 1.

As for the measurement for the depth direction, the same wafer was repeatedly subjected to the thermal oxidation treatment, and LPD was measured when the position of the interface between the thermal oxide film and silicon reached a depth from the original wafer surface of about 50 nm, 120 nm, 180 nm or 270 nm. The obtained measurement values are represented in terms of numbers of LDP in a unit volume.

From the results shown in Fig. 1, it was found that the void defect density for those having a size of 0.09 µm or more was 1 × 10⁴ defects/cm³ or less over the whole region of the depth measured.

Thereafter, when thickness of the oxide film formed on the surface became about 1 µm, this oxide film was removed with an aqueous HF solution, and the oxide dielectric breakdown voltage characteristic (TZDB characteristic) at the depth of about 0.5 µm from the wafer surface was determined. The conditions for the measurement of TZDB characteristic included oxide film thickness: 25 nm, measurement electrode: phosphorus-doped polysilicon, electrode area: 8 mm, and current density in decision: 1 mA/cm². The measurement results were shown in Fig. 2 as Curve B.

From Curve B shown in Fig. 2, it can be seen that the C-mode good chip yield (ratio of dielectric breakdown electric field of 8 MV or more) was 95% or more. This represents the almost same TZDB characteristics as ordinary epitaxial wafers. Therefore, it was found that the wafer of the present invention had the almost same TZDB characteristics as epitaxial wafers also at a depth of about 0.5 µm from the surface.

Further, when boron concentration at a position near the surface, i.e., a position at a depth of about 0.5 µm from the surface of the original wafer, was measured by a secondary ion mass spectroscopy apparatus, the boron concentration was about 1 × 10¹⁷ number/cm³. Therefore, it could be confirmed that the boron concentration at a position near the surface was sufficiently reduced compared with the bulk portion after the heat treatment in the hydrogen atmosphere.

Furthermore, in order to confirm the gettering ability of this wafer, the wafer was subjected to oxygen precipitation heat treatment at 800°C for 4 hours in a nitrogen atmosphere and at 1000°C for 16 hours in an oxygen atmosphere, and then bulk micro defect density of the bulk portion was measured by the OPP (Optical Precipitate Profiler) method.

In this OPP method, which utilizes a Nomarski differential interference microscope, a laser light emitted from a light source is first separated into two linearly polarized light beams by a polarizing prism, which are orthogonally intersects with each other and have phases different by 90°, and the beams are entered into a wafer from the wafer mirror surface side. At that time, when one beam passes a defect, phase shift is caused and hence phase difference between the two beams is produced. This phase difference is detected by a polarization analyzer after the beams transmit the wafer back face to detect the defect.

As a result, the bulk micro defect density was 5 × 10⁹ defects/cm³. Therefore, it was found that, even though the wafer of the present invention was subjected to a heat treatment at 1200°C for 60 minutes in a hydrogen atmosphere, the oxygen precipitation nuclei formed at the as-grown point were not eliminated, and a bulk micro defect density sufficient for gettering (1 × 10⁸ defects/cm³ to 2 × 10¹⁰ defects/cm³) could be obtained by the subsequent heat treatment.

### (Comparative Example)

A mirror-polished wafer was produced with the same conditions as the example without the nitrogen doping, and void defect density along the depth direction was measured for such a wafer subjected or not subjected to the same hydrogen heat treatment as the example. The results are also shown in Fig. 1. From the results shown in Fig. 1, it can be seen that, while the void defects of 0.09 µm or more could be reduced in a certain degree for a depth of around 50 nm or less, the density of defects in a deeper region was comparable to that of the wafer not subjected to the hydrogen heat treatment.

Further, as for the wafer subjected to the hydrogen heat treatment, the TZDB characteristic at a depth of about 0.5 µm was investigated in the same manner as the example. The results are also shown in Fig. 2 as Curve A. From the results shown as Curve A, it was found that the C-mode good chip yield was about 60% at a depth of about 0.5 µm for the wafer not doped with nitrogen but subjected to the hydrogen heat treatment, and it was considerably inferior to that of ordinary epitaxial wafers.

The present invention is not limited to the embodiments described above. The above-described embodiments are mere examples, and those having the substantially same structure as that described in the appended claims and providing the similar functions and advantages are included in the scope of the present invention.

For example, when a silicon single crystal ingot doped with nitrogen is grown by the Czochralski method according to the present invention, the melt may be or may not be applied with a magnetic field. That is, the Czochralski method used for the present invention includes the so-called MCZ method wherein a magnetic field is applied to the melt.

Further, although the aforementioned embodiments were mainly explained for p/p⁺ wafers having a low crystal defect density in wafer. surface layers comparable to that of epitaxial wafers, the present invention is not limited to these. The silicon wafer of the present invention also include p/p⁻ wafers so long as they are silicon wafers doped with boron and nitrogen and have a boron concentration in surface layers of a depth of at least 0.2 µm less than 1/2 of the boron concentration in bulk portions, a defect density of 1.0 × 10⁴ defects/cm³ in the surface layers for defects having a size of 0.09 µm or more, and a bulk micro defect density of 1 × 10⁸ defects/cm³ to 2 × 10¹⁰ defects/cm³ in bulk portions.

## Claims

1. A silicon wafer doped with boron and nitrogen, wherein boron concentration in a surface layer of a depth of at least 0.2 µm from a surface of the silicon wafer is 1/2 or less of boron concentration of bulk portion, density of defects having a size of 0.09 µm or more in the surface layer is 1.0 × 10¹⁴ defects/cm³ or less, and density of bulk micro defects in the bulk portion after oxygen precipitation heat treatment is 1 × 10⁸ to 2 × 10¹⁰ defects/cm³.

2. The silicon wafer according to Claim 1, wherein nitrogen concentration of the silicon wafer is 1 × 10¹⁰ to 5 × 10¹⁵ number/cm³.

3. The silicon wafer according to Claim 1 or 2, wherein the boron concentration in the bulk portion of the silicon wafer is 1 × 10¹⁷ number/cm³ or more.

4. A method for producing a silicon wafer, which comprises growing a silicon single crystal ingot doped with boron and nitrogen by the Czochralski method, processing the single crystal ingot into a silicon wafer by slicing the ingot, and subjecting the silicon wafer to a heat treatment in a hydrogen-containing atmosphere to out-diffuse boron of wafer surface.

5. The method for producing a silicon wafer according to Claim 4, wherein, when a silicon single crystal ingot doped with boron and nitrogen is grown by the Czochralski method, concentration of nitrogen doped in the single crystal ingot is controlled to be 1 × 10¹⁰ to 5 × 10¹⁵ number/cm³.

6. The method for producing a silicon wafer according to Claim 4 or 5, wherein, when a silicon single crystal ingot doped with boron and nitrogen is grown by the Czochralski method, concentration of boron doped in the single crystal ingot is controlled to be 1 × 10¹⁷ number/cm³ or more.

7. The method for producing a silicon wafer according to any one of Claims 4-6, wherein the hydrogen-containing atmosphere is 100% hydrogen atmosphere, and temperature of the heat treatment is 1100°C or more.
